(19) Europäisches Patentamt
European Patent Office
Office européen des brevets

(11) **EP 3 227 717 B1**

(12) **EUROPÄISCHE PATENTSCHRIFT**

(45) Veröffentlichungstag und Bekanntmachung des Hinweises auf die Patenterteilung:
**08.12.2021  Patentblatt 2021/49**

(21) Anmeldenummer: **15778255.8**

(22) Anmeldetag: **05.10.2015**

(51) Int Cl.:
*G01S 13/93* (2020.01)   *G01S 19/13* (2010.01)
*G01S 19/45* (2010.01)   *G01S 19/47* (2010.01)
*G01S 7/292* (2006.01)   *G01S 7/35* (2006.01)
*H03H 17/02* (2006.01)   *H03H 21/00* (2006.01)

(86) Internationale Anmeldenummer:
**PCT/EP2015/072896**

(87) Internationale Veröffentlichungsnummer:
**WO 2016/087087 (09.06.2016 Gazette 2016/23)**

(54) **VERFAHREN UND VORRICHTUNG ZUM BESTIMMEN STATISTISCHER EIGENSCHAFTEN VON ROHMESSWERTEN**

METHOD AND DEVICE FOR DETERMINING STATISTICAL PROPERTIES OF RAW MEASURED VALUES

PROCÉDÉ ET DISPOSITIF DE DÉTERMINATION DE PROPRIÉTÉS STATISTIQUES DE VALEURS DE MESURE BRUTES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.12.2014  DE 102014224911**

(43) Veröffentlichungstag der Anmeldung:
**11.10.2017  Patentblatt 2017/41**

(73) Patentinhaber: **Robert Bosch GmbH**
**70442 Stuttgart (DE)**

(72) Erfinder:
• **VOGEL, Andreas**
**31139 Hildesheim (DE)**
• **KRYKUNOVA, Kateryna**
**31137 Hildesheim (DE)**

(56) Entgegenhaltungen:
**EP-A2- 0 784 213      DE-C1- 4 427 656**
**US-A1- 2014 218 226**

• **BRAASCH ET AL: "A SIGNAL MODEL FOR GPS", NAVIGATION, Bd. 37, Nr. 4, 1. März 1991 (1991-03-01), Seiten 363-378, XP056004085, ISSN: 0028-1522**
• **None**

**Beschreibung**

Stand der Technik

Viele technische Systeme sind aus Modulen aufgebaut. Dabei werden Informationen, d.h. Daten enthaltende Datensignale, zwischen den Modulen ausgetauscht, d.h. von einem Modul in ein benachbartes Modul übertragen. Diese Module müssen räumlich nicht unbedingt dicht benachbart liegen. Da Übertragungskanäle in ihrer Datenrate beschränkt sind, werden häufig nur reduzierte Informationen von einem Modul in ein benachbartes Modul übertragen. Ein Beispiel dafür ist ein Radarsystem einer Einrichtung für ein Fahrzeug zur automatischen Abstandsregelung per Radar, kurz "ACC". Von diesem Radarsystem wird eine große Menge an Messdaten aufgenommen, aus denen abgeleitet aber nur ein aktueller Abstand zu einem oder mehreren vorausfahrenden Fahrzeugen und deren relative Geschwindigkeiten übertragen werden. Alle weiteren Informationen, z.B. wie gut die Empfangsbedingungen waren, gehen dabei verloren. Das ist aber für die weitere Verarbeitung der Signale, d.h. Daten, vor allem für eine Einschätzung, wie vertrauenswürdig die Signale sind, extrem wichtig. Ein anderes Beispiel ist eine Positionsbestimmung mittels Satellitennavigationssystemen, kurz "GNSS". Von einem GNSS-Modul wird meist nur eine Position übertragen. Wie sicher die Messung der Position war, d.h. von welcher Qualität die Empfangsbedingungen waren, ist aus der Angabe der Position nicht ersichtlich. Diese Information ist aber sehr wichtig für eine weitere Verarbeitung dieser Position, z.B. für eine Kombination mit anderen Sensorsignalen.

Allgemein stehen häufig nur die Ergebnisse eines Filter- und/oder Auswertevorgangs ohne weitere Informationen zur Verfügung. Ein Nutzer benötigt häufig zusätzlich statistische Aussagen über die augenblicklichen, tatsächlichen, d.h. echten, Messdaten, wie sie als Rohmesswerte, d.h. Rohmessdaten, vor dem Filtervorgang vorgelegen haben. Für derartige statistische Aussagen werden typischerweise Varianzen der Messwerte herangezogen.

Nachfolgend wird auf die Theorie linearer Filter, insbesondere die Kalman-Filtertheorie Bezug genommen, die von sehr einfachen Filtern, wie z.B. Tiefpassfiltern, bis hin zu optimale Beobachter bildenden Kalman-Filtern die Filterung von Rohmesswerten in ein Nutzsignal betrifft. Wie aus der Internet-Enzyklopädie "Wikipedia" - vgl. den Internetauftritt "http://de.wikipedia.org", Stichwort "Kalman-Filter", Eintrag gelesen am 18.19.2014 um 16:56 Uhr - entnehmbar, ist das Kalman-Filter ein Satz mathematischer Gleichungen, mittels derer bei Vorliegen fehlerbehafteter Beobachtungen Rückschlüsse auf den Zustand vieler technischer Systeme möglich sind. Vereinfacht umschrieben dient das Kalman-Filter zum Entfernen von durch Messgeräte verursachter Störungen. Dabei müssen sowohl die mathematische Struktur eines zugrundeliegenden dynamischen Systems, mit dem zu filternde Messungen vorgenommen werden, als auch die der Messverfälschungen bekannt sein.

Aus der Monographie "Adaptive Filtering and Change Detection" von Fredrik Gustafsson, John Wiley & Sons, Ltd; Copyright 2000, ISBN 0-471-49287-6, Seite 312, ist bekannt, dass das Messrauschen aus dem Filterergebnis berechnet werden kann, wenn der komplette Filteraufbau und die vollständige Information über die Filterwerte und deren statistische Charakteristika, insbesondere die Varianzen, bekannt sind.

BRAASCH ET AL: "A SIGNAL MODEL FOR GPS", NAVIGATION, Bd. 37, Nr. 4,1. März 1991 (1991-03-01), Seiten 363-378, XP056004085 beschreibt ein Signalmodell für GPS.

Offenbarung der Erfindung

Die Erfindung hat die Aufgabe, ohne Detailkenntnis eines Filtervorgangs bzw. Filters für die Rohmesswerte und nur unter Zuhilfenahme von Ausgabewerten des Filters, d.h. eines aus den Rohmesswerten durch den Filtervorgang gewonnenen Nutzsignals, statistische Eigenschaften der Rohmesswerte, insbesondere Messrauschen und/oder mittleren Fehler, wenigstens näherungsweise zu bestimmen, d.h. unter Annahme einiger häufig anzutreffender Randbedingungen auch ohne Kenntnis des genauen Filters Aussagen über die Messbedingungen zu treffen.

Diese Aufgabe wird gelöst durch ein Verfahren zum Bestimmen statistischer Eigenschaften von Rohmesswerten gemäß Anspruch 1.

Das erfindungsgemäße Verfahren besteht aus zwei Teilen. In Zeiten konstanter Messungen werden die Filtercharakteristika gelernt. Ist das Filterverhalten hinreichend genau bekannt, kann der unbekannte Filter, d.h. dessen Filtercharakteristik, invertiert und können damit Aussagen über die Messbedingungen getroffen werden. Dabei kann im zweiten dieser Schritte die Ermittlung der statistischen Eigenschaften, und zwar einer Varianz, wahlweise unmittelbar oder über die Rekonstruktion der Rohmesswerte erfolgen. Das Verfahren umfasst mittels der Varianz nur aus dem Nutzsignal und auch ohne genaue Kenntnis des Filters das Treffen einer Aussage über die Messbedingungen. Die Erfindung ermöglicht, auch bei einer Übertragung des Nutzsignals mit beschränkter, nur eine Übertragung reduzierter Informationen zulassender Datenrate zusätzliche Informationen über die Rohmesswerte bereitzustellen, deren Übertragung aufgrund der beschränkten Datenrate nicht möglich ist.

Gemäß einer bevorzugten Weiterbildung des erfindungsgemäßen Verfahrens wird ein Vorliegen stabiler Messbedingungen aus einer Auswertung der zeitlichen Folge der Ausgabewerte und/oder aus einer Auswertung von Sensorsignalen weiterer Sensoreinrichtungen erkannt. Damit ist eine Auswertung lediglich des Nutzsignals erforderlich. Als derartige weitere Sensoreinrichtungen können z.B. in einem Fahrzeug zusätzlich zu einer Radar-Abstandsmessung oder einer Positionsbestimmung mittels GNSS-Wegsensoren, Beschleunigungssensoren und/oder optische Sensoren dienen.

Bei einer weiteren bevorzugten Ausführungsform des erfindungsgemäßen Verfahrens wird ein Vorliegen stabiler Messbedingungen aus einer zeitlichen Folge wenigstens nahezu gleichmäßiger, vorzugsweise zeitlich wenigstens nahezu konstanter oder zeitlich wenigstens nahezu gleichförmig gemäß einem dem Filter zugrundeliegenden Systemmodell sich ändernder, Ausgabewerte erkannt. Je nach Anwendungsfall können für ein Bestimmen der Filtercharakteristik hinreichend stabile Messbedingungen vorliegen, wenn das Nutzsignal oder seine zeitliche Änderung zeitlich konstant sind.

Gemäß einer bevorzugten Weiterbildung des erfindungsgemäßen Verfahrens wird der Filtervorgang gemäß einer Tiefpassfilterung vorgenommen. Dies stellt einen sehr einfachen Anwendungsfall dar. Nach einer anderen Ausführungsform des erfindungsgemäßen Verfahrens wird der Filtervorgang gemäß einer Kalman-Filterung vorgenommen. Damit lassen sich auch komplexere Filtervorgänge beschreiben.

Erfindungsgemäß findet das Lernen der Filtercharakteristika in Perioden statt, wenn die Messbedingungen gutartig und stabil sind, wobei dies vom jeweiligen Anwendungsfall abhängt. In den obigen Fällen ist das z.B., dass ein vorausfahrendes Fahrzeug im gleichen oder sich gleichmäßig ändernden Abstand verfolgt wird. Bei der Positionsbestimmung ist das z.B. eine konstante Fahrt ohne Beschleunigungen usw. Dieser Zustand kann an Hand sehr gleichmäßiger Ausgabewerte des Filters oder auch auf Basis anderer Messungen erkannt werden, z.B. über eine optische Kamera beobachtet, eine Beschleunigung über Beschleunigungssensor gemessen werden, usw. Die Messbedingungen ändern sich z.B. bei einer Fahrt auf einer Autobahn o.ä. nicht wesentlich. Wendet man das Lernen in einem Fahrzeug an, kann aus der bekannten Tatsache, dass die überwiegende Mehrheit aller Fahrten im Mittel unbeschleunigt und geradeaus verläuft, den Lernvorgang kontinuierlich ablaufen lassen. Dabei wird durch das Verfahren im Mittel das korrekte mittlere Verhalten, d.h. ein Langzeitmittel der Filtercharakteristika, gelernt. Vollständigkeitshalber ist für jeden Vorgang zu untersuchen, ob die Annahme dieser Mittelung über lange Zeiträume korrekt ist.

Die Erfindung geht insbesondere von einem linearen Filter aus. Der Systemprozess kann als bekannt angenommen werden. In den oben beschriebenen Beispielen sind das die Newtonschen Gesetze. Dabei ist die Wahl des Messprinzips unwesentlich, es kommt auf das physikalische Prinzip der Entwicklung des System-Zustandes an, der durch das Verfahren beobachtet werden soll. Wichtig ist außerdem, dass ein Filter für den gesamten Bereich der Messungen gilt, also z.B. kein gesondertes Filter für z.B. sehr geringe Geschwindigkeiten o.ä. benötigt wird.

Die oben genannte Aufgabe wird weiterhin gelöst durch eine Vorrichtung gemäß Anspruch 5.

Die Einrichtung zum Gewinnen von Rohmesswerten umfasst bevorzugt wenigstens eine Messeinrichtung und/oder wenigstens eine Übertragungseinrichtung, durch die die Rohmesswerte dem Filter zugeführt werden. Zwischen dem Filter und der Nutzsignalverarbeitungseinheit wird nur das Nutzsignal mit einer Datenrate übertragen, die geringer ist als eine Datenrate der Rohmesswerte, bevorzugt klein gegenüber dieser.

Die erfindungsgemäße Vorrichtung ermöglicht auf einfache Weise, nur aus dem Nutzsignal und auch ohne genaue Kenntnis des Filters, Aussagen über die Messbedingungen zu treffen, unter denen die Rohmesswerte gewonnen wurden.

Die oben genannte Aufgabe wird außerdem gelöst durch ein Computerprogrammprodukt nach Anspruch 6, aufweisend Programmteile zum Ausführen des beschriebenen Verfahrens, eine maschinenlesbare, insbesondere computerlesbare, Datenstruktur, erzeugt durch ein derartiges Verfahren und/oder durch mindestens ein derartiges Computerprogrammprodukt, sowie durch einen maschinenlesbaren, insbesondere computerlesbaren, Datenträger, auf dem mindestens ein solches Computerprogrammprodukt aufgezeichnet und/oder gespeichert ist und/oder auf dem mindestens eine solche Datenstruktur zum Abruf bereit gehalten ist.

Ein Ausführungsbeispiel der Erfindung wird anhand der einzigen Figur der Zeichnung beschrieben, die ein grobschematisches Blockschaltbild einer erfindungsgemäßen Vorrichtung 100 zum Durchführen des erfindungsgemäßen Verfahrens zeigt. Eine Einrichtung 101 zum Gewinnen von Rohmesswerten 102 ist z.B. mit einem Abstandsradar eines Fahrzeugs ausgebildet. Ein Filter 103 dient zum Gewinnen eines Nutzsignals 104, z.B. eines Abstandssignals, aus den Rohmesswerten 102. Über einen Übertragungskanal 107 geringer Datenübertragungsrate wird das Nutzsignal 104 an eine Nutzsignalverarbeitungseinheit 105 übertragen, die eine Auswerteeinheit 106 zum Ermitteln einer Filtercharakteristik des Filters 103, Rekonstruieren der Rohmesswerte 102 und Ermitteln statistischer Eigenschaften der Rohmesswerte 102 aufweist. Eine Verbindung 108 dient zum Datenverkehr zwischen der Nutzsignalverarbeitungseinheit 105 und der Auswerteeinheit 106.

Das Verfahren gemäß dem Ausführungsbeispiel wird anhand folgender Bezeichnungen und Abkürzungen beschrieben:

| Bezeichnung / Abkürzunq | Beschreibung |
|---|---|
| E | Erwartungswert einer Zufallsgröße, wird dadurch erhalten, dass die Zufallsgröße mit ihrer Dichtefunktion multipliziert von -unendlich bis +unendlich integriert wird |
| Varianz, z.B. Q, R, P, F | Die Varianz einer Zufallsgröße ist gleich dem Quadrat ihrer Standardabweichung und wird dadurch erhalten, dass die mit dem Quadrat der Abweichung der Zufallsgröße vom Erwartungswert multiplizierte Dichtefunktion von -unendlich bis +unendlich integriert wird |
| A | Transitionsmatrix, auch als Modell bezeichnet |
| H | Messmatrix |
|  | Einheitsmatrix (also nur Einsen auf der Diagonalen) |
| q; Q | Systemrauschen mit zuqehöriqer Varianz |
| v; R | Messrauschen mit zugehöriger Varianz |
| p; P | Fehler im Systemvektor, also Differenz zwischen echtem und geschätztem Wert mit zugehöriger Varianz |
| z | Aktueller Messwert |
| $\tilde{x}$ / x | Wahrer / geschätzter Wert des Systemvektors bzw. des Ausgabewerts |
| P_ | "-" gibt den Wert nach der Prädiktion an. |
| $P_+$ | "+" bezeichnet den Wert am Ende eines Filterschrittes. Werte ohne + oder - sind immer auf das Ende des Filterschrittes bezogen, also +. Störgrößen tragen kein + oder - |
| K | Kalman-Filter-Gewinn |
| d | Differenz zwischen Filterergebnis zu der Filterprädiktion: $x_{n+1}$ - $Ax_n$ <br> Diese Differenz ist die sogenannte Filterinnovation. |
| F | Varianz der Filterinnovation, also F=E(d,d) |
| Statistische Charakteristika | Der Erwartungswert und die Varianz einer Zufallsgröße. |
| Filtercharakteristik | In einem Tiefpassfilter ist das die Filterkonstante, in einem Kalman-Filter ist es das zusätzliche Systemrauschen, das zu bestimmen ist. |
| Ausgabewert eines Filters | Das Ergebnis der Berechnungen des Filters, also die Schätzung x für den wahren Wert $\tilde{x}$ |
| System position | Synonym für Ausgabewert eines Filters im Fall eines Kalman-Filters. |
| Systemvarianz P | Die Varianz der Differenz zwischen wahrem und geschätztem Wert, also $\tilde{x} - x$ |

Es wird ein Systemmodell nach folgenden Gleichungen angenommen:

$$\widetilde{x}_{n+1} = A \cdot \widetilde{x}_n - q_{n+1}$$

$$z_n = H \cdot \widetilde{x}_n + v_n$$

Der wahre Wert des Systemvektors wird mit der Transitionsmatrix A propagiert, und es kommt ein Rauschen hinzu. In den aktuellen Messwert geht ebenfalls ein Rauschen ein. Für das Rauschen gilt:

$$P = E(x - \widetilde{x}, x - \widetilde{x})$$

$$q \in N(0,Q)$$

$$v \in N(0,R)$$

wobei $N(0,Q)$ bzw. $N(0,R)$ die Normalverteilung mit einem Erwartungswert 0 und einer Varianz Q bzw. R ist. Ein beliebiger Wert kann immer als Summe des wahren Wertes und des Fehlerwerts ausgedrückt werden. Die Fehlerwerte sind untereinander nicht korreliert.

Ein solches System kann z.B. mittels eines durch folgende Formeln beschriebenen Kalman-Filters beobachtet werden. Dabei ist mit $P_-$ der Wert nach der Prädiktion, mit $P_+$ der Wert nach der Korrektur und mit dem hochgestellten T bei den Größen $A^T$ und $H^T$ die Transponierte der entsprechend gekennzeichneten Matrix bezeichnet:

$$x_- = Ax_+$$

$$P_- = AP_+A^T + Q$$

$$K = P_-H^T\left(HP_-H^T + R\right)^{-1}$$

$$x_+ = x_- + K\left(z - Hx_-\right)$$

$$P_+ = \left(I - KH\right)P_-$$

Nachfolgend wird eine detaillierte Herleitung der Formeln für ein einfaches Tiefpassfilter gezeigt. Das dortige Prinzip ist auf Kalman-Filter anwendbar, dort nur mathematisch anspruchsvoller. Für das Tiefpassfilter gelten die Formeln:

$$x_{n+1} = \lambda x_n + (1 - \lambda)z_{n+1}$$

$$P = E(x,x)$$

$$R = E(z,z)$$

P ist die Systemvarianz, R das Messrauschen, $\lambda$ die Filterkonstante.

In Zeiten des eingeschwungenen Zustandes kann davon ausgegangen werden, dass das Messrauschen und auch die Kovarianz des Filters ungefähr konstant sind. Unter dieser Annahme kann die Filtercharakteristik gelernt werden. Im Tiefpassfilter ist dazu die Filterkonstante, im Kalman Filter das Systemrauschen zu bestimmen.

Liegt ein konstanter, eingeschwungener Zustand vor, kann die Systemvarianz im Laufe der Zeit aus den Ausgabewerten des Filters gemessen werden:

$$P = E(\dot{x}_n, \dot{x}_n)$$

Genauso kann die Varianz der Filterinnovation experimentell gemessen werden:

$$F = E(x_{n+1} - x_n, x_{n+1} - x_n)$$

Diese Filterinnovation lässt sich umschreiben zu:

$$F = E(x_{n+1} - x_n, x_{n+1} - x_n) = E(\lambda x_n + (1-\lambda)z - x_n, \lambda x_n + (1-\lambda)z - x_n) =$$
$$= (\lambda - 1)^2 (P + R)$$

Da ein eingeschwungener Zustand herrscht, gilt aber ebenso:

$$P = E(x_{n+1}, x_{n+1}) = E(\lambda x_n + (1-\lambda)z, \lambda x_n + (1-\lambda)z) = \lambda^2 P + (1-\lambda)^2 R$$

Es lässt sich berechnen:

$$P - F = \lambda^2 P + (1-\lambda)^2 R - (\lambda - 1)^2 (P + R) = (2\lambda - 1)P$$

Damit ist die Filtercharakteristik, also in dem Fall eines Tiefpassfilters die Filterkonstante, aus der Gleichung

$$2(1-\lambda)P = F$$

bestimmbar. Es kann also nur unter Zuhilfenahme der Ausgabewerte und ohne Kenntnis des Messrauschens die Filterkonstante berechnet werden.

Für ein Kalman-Filter ist die Herleitung wie folgt:

$$d_{n+1} = x_{n+1} - Ax_n =$$
$$= A\tilde{x}_n - q_{n+1} + (I - KH)(Ap_n + q_{n+1}) + Kv_{n+1} - A(\tilde{x}_n + p_n)$$
$$= K(v_{n+1} - H(Ap_n + q_{n+1})) \tag{1}$$

Daraus ergibt sich:

$$F = E(\dot{d}_{n+1}, \dot{d}_{n+1}) = E(K(v_{n+1} - H(Ap_n + q_{n+1})), K(v_{n+1} - H(Ap_n + q_{n+1})))$$
$$= K(R + H(APA^T + Q)H^T)K^T = KH(APA^T + Q)$$

Dabei wurden für die Herleitung die Formeln des Kalman Filters genutzt. Die Varianzen F der Filterinnovation und P des Fehlers im Systemvektor sind direkt messbar. Im eingeschwungenen Zustand gilt $P \approx const$, und aus der obigen Gleichung

$$P_+ = (I - KH)P_-$$

ergibt sich damit:

$$P = (I - KH)(APA^T + Q)$$

Woraus folgt:

$$P = APA^T + Q - F$$

Da P und F messbar sind und die Transitionsmatrix A aus dem physikalischen Modell bekannt ist, kann damit die Varianz Q des Systemrauschens bestimmt werden.

Zum Ermitteln des Messrauschens im zweiten Verfahrensschritt gemäß der Erfindung kann im Beispiel des einfachen Tiefpassfilters das Rauschen der Rohmesswerte aus der Differenz der Filterwerte berechnet werden, wenn die Filtercharakteristika bekannt sind. Aus

$$x_{n+1} = \lambda x_n + (1 - \lambda)z_{n+1}$$

sind bei bekannten Werten für $x_n$ und $x_{n+1}$ sowie berechnetem $\lambda$ die Rohmesswerte rekonstruierbar:

$$z_{n+1} = \frac{x_{n+1} - \lambda x_n}{(1 - \lambda)}$$

Damit sind die statistischen Charakteristika, d.h. die Varianzen usw., des Nutzsignals, d.h. des Ausgangssignals des Tiefpassfilters, ermittelbar.

Bei Kalman-Filtern hängt der Wert, wie stark die letzte Systemposition und die aktuelle Messung eingefiltert werden, von den jeweiligen Kovarianzen ab. Ist die Systemvarianz P sehr groß, wird sich mehr auf die Messwerte verlassen. Sind die Messungen unsicher, wird sich mehr auf das dem Filter zugrunde liegende physikalische Systemmodell, also auf die Gleichung

$$\tilde{x}_{n+1} = A \cdot \tilde{x}_n - q_{n+1}$$

des Systemmodells verlassen. Erfindungsgemäß wird vorgeschlagen, zum Invertieren des Kalman-Filters die Gleichung der Filterinnovation d, die in jedem Schritt direkt gemessen werden kann, zu nutzen. Die zugehörige Gleichung, vgl. Formel (1), s.o., lautet:

$$d_{n+1} = K(v_{n+1} - H(Ap_n + q_{n+1}))$$ ,

mit

$$K = P\_H^T \left( HP\_H^T + R \right)^{-1}$$

Dabei sind die Zufallswerte v, p, q aus den Normalverteilungen N(0,R), N(0,P) und N(0,Q) zu wählen, wobei P und Q bekannt sind. Es ist lediglich noch die Varianz R des Messrauschens v zu bestimmen. Für diese Bestimmung sind verschiedene, numerische Rechenverfahren anwendbar, die grundsätzlich bekannt sind. Als bevorzugtes Beispiel eines solchen Rechenverfahrens wird die Monte-Carlo-Methode genannt.

Dabei ergeben sich typischerweise zwei wahrscheinliche Lösungen für die Varianz R des Messrauschens v. Da das Messrauschen, d.h. der Messfehler, v einmal im Zähler und einmal als zugehörige Varianz im Nenner eingeht, ergibt sich eine Art quadratischer Gleichung bezüglich v bzw. R. Eine quadratische Gleichung hat typischerweise zwei Lösungen. Welche von beiden die richtige ist, kann aus der Kenntnis, ob es z.B. eine gute Empfangsgegend oder eher eine schlechte Gegend ist, ermittelt werden. Diese Kenntnis, d.h. ein entsprechendes Signal, kann als einzige Zusatzinformation z.B. von der Einrichtung 101 ermittelt und übertragen und in einem dafür vorgesehenen Speicher, insbesondere einem Flag, abgelegt sein. Die Zusatzinformation beinhaltet lediglich, ob das tatsächliche Messrauschen vor dem Filtervorgang eher gut oder eher schlecht ist, und benötigt zur Übertragung allenfalls eine vernachlässigbar geringe Datenrate. Damit kann mit dem hier vorgeschlagenen Verfahren eine zumindest weitgehend exakte quantitative Aussage über das Messrauschen vor dem Filtervorgang getroffen werden.

Die Unterscheidung der beiden vorgenannten Lösungen kann auch wie folgt verdeutlicht werden. Wenn das Filterergebnis sehr dicht am Erwartungswert des ungestörten physikalischen Modells liegt, kann einmal die Messung perfekt sein und genau das physikalische Modell bestätigen, oder die Messbedingungen sind so schlecht, dass die Messung faktisch keinen Einfluss auf das Filterergebnis hatte. Zwischen diesen Extrema muss unterschieden werden. Da die Werte des Messrauschens für beide Fälle als Lösungen der Gleichung bekannt sind, kann regelmäßig leicht an Hand weiterer Heuristiken zwischen den beiden Lösungen unterschieden werden.

Die vorstehend beschriebenen Verfahren zum Verarbeiten der Rohmesswerte und der daraus abgeleiteten physikalischen Größen bzw. Signale sind einfach und vorteilhaft insbesondere mit digitalen Signalprozessoren ausführbar.

**Patentansprüche**

1. Verfahren zum Bestimmen statistischer Eigenschaften von Rohmesswerten (102) aus einem aus einem Filtervorgang in einem Filter (103) gewonnenen, aus einer zeitlichen Folge von Ausgabewerten des Filters gebildeten Nutzsignal (104), wobei Z in einem ersten Schritt mittels einer Einrichtung (101) Rohmesswerte (102) gewonnen und mittels des Filters (103) aus den Rohmesswerten (102) das Nutzsignal (104) ermittelt wurde, wobei in einem Z zweiten Verfahrensschritt mittels einer Auswerteeinheit (106) aus einer unter stabilen Messbedingungen gewonnenen zeitlichen Folge von Ausgabewerten eine Filtercharakteristik des Filters (103) ermittelt wird und in einem dritten Verfahrensschritt die ermittelte Filtercharakteristik invertiert, aus dem Inversen der Filtercharakteristik und dem Nutzsignal (104) Rohmesswerte (102) rekonstruiert und aus den rekonstruierten Rohmesswerten (102) deren statistische Eigenschaften und/oder diese statistischen Eigenschaften unmittelbar aus dem Inversen der Filtercharakteristik und dem Nutzsignal (104) ermittelt werden, , wobei es sich bei den statistischen Eigenschaften um eine Varianz handelt, wobei das Verfahren mittels der Varianz nur aus dem Nutzsignal und auch ohne genaue Kenntnis des Filters das Treffen einer Aussage über die Messbedingungen umfasst, wobei ein Vorliegen stabiler Messbedingungen

   (a) aus einer Auswertung der zeitlichen Folge der Ausgabewerte und/oder
   (b) aus einer Auswertung von Sensorsignalen weiterer Sensoreinrichtungen erkannt wird.

2. Verfahren nach Anspruch 1, **dadurch gekennzeichnet, dass** ein Vorliegen stabiler Messbedingungen aus einer zeitlichen Folge wenigstens nahezu gleichmäßiger, vorzugsweise zeitlich wenigstens nahezu konstanter oder zeitlich wenigstens nahezu gleichförmig gemäß einem dem Filter (103) zugrundeliegenden Systemmodell sich ändernder, Ausgabewerte erkannt wird.

3. Verfahren nach einem oder mehreren der vorhergehenden Ansprüche, **dadurch gekennzeichnet, dass** der Filtervorgang gemäß einer Tiefpassfilterung vorgenommen wird.

4. Verfahren nach einem oder mehreren der Ansprüche 1 bis 3, **dadurch gekennzeichnet, dass** der Filtervorgang gemäß einer Kalman-Filterung vorgenommen wird.

5. Vorrichtung (100) zum Durchführen eines Verfahrens nach einem oder mehreren der vorhergehenden Ansprüche, umfassend eine Einrichtung (101) von Rohmesswerten zum Gewinnen von Rohmesswerten, einen Filter (103) zum Gewinnen eines Nutzsignals (104) aus den Rohmesswerten (102) sowie eine eine Auswerteeinheit (106) zum Ermitteln einer Filtercharakteristik des Filters (103), Rekonstruieren der Rohmesswerte (102) und Ermitteln statistischer Eigenschaften der Rohmesswerte (102) aufweisende Nutzsignalverarbeitungseinheit (105).

6. Computerprogrammprodukt, aufweisend Programmteile die bei der Ausführung des Programms durch einen Computer diesen veranlassen, eines der Verfahren nach mindestens einem der voranstehenden Ansprüche 1 bis 4 auszuführen.

7. Maschinenlesbarer, insbesondere computerlesbarer, Datenträger, auf dem mindestens ein Computerprogrammprodukt gemäß Anspruch 6 aufgezeichnet und/oder gespeichert ist:

**Claims**

1. Method for determining statistical properties of raw measured values (102) from a wanted signal (104) obtained from a filtering process in a filter (103) and formed from a temporal sequence of output values of the filter, wherein, in a first step, raw measured values (102) were obtained by means of a device (101) and the wanted signal (104) was ascertained from the raw measured values (102) by means of the filter (103), wherein, in a second method step, a filter characteristic of the filter (103) is ascertained by means of an evaluation unit (106) from a temporal sequence of output values obtained under stable measuring conditions and, in a third method step, the ascertained filter characteristic is inverted, raw measured values (102) are reconstructed from the inverse of the filter characteristic and the wanted signal (104) and from the reconstructed raw measured values (102) their statistical properties are ascertained and/or these statistical properties are ascertained directly from the inverse of the filter characteristic and the wanted signal (104), wherein the statistical properties are a variance, wherein the method comprises making a statement about the measuring conditions only from the wanted signal, and even without exact knowledge of the filter, by means of the variance, wherein an existence of stable measuring conditions is detected

(a) from an evaluation of the temporal sequence of the output values and/or

(b) from an evaluation of sensor signals of further sensor devices.

2. Method according to Claim 1, **characterized in that** an existence of stable measuring conditions is detected from a temporal sequence of at least almost uniform output values, which are preferably at least almost constant over time or at least change almost uniformly over time according to a system model forming the basis of the filter (103).

3. Method according to one or more of the preceding claims, **characterized in that** the filtering process is performed according to a low-pass filtering.

4. Method according to one or more of Claims 1 to 3, **characterized in that** the filtering process is performed according to a Kalman filtering.

5. Apparatus (100) for carrying out a method according to one or more of the preceding claims, comprising a device (101) for obtaining raw measured values, a filter (103) for obtaining a wanted signal (104) from the raw measured values (102) and also a wanted-signal processing unit (105), having an evaluation unit (106) for ascertaining a filter characteristic of the filter (103), reconstructing the raw measured values (102) and ascertaining statistical properties of the raw measured values (102).

6. Computer program product, having program parts which, when the program is executed by a computer, cause it to perform one of the methods according to at least one of the preceding Claims 1 to 4.

7. Machine-readable, in particular computer-readable, data carrier on which at least one computer program product according to Claim 6 is recorded and/or stored.

**Revendications**

1. Procédé permettant de déterminer des propriétés statistiques de valeurs de mesure brutes (102) à partir d'un signal utile (104) obtenu à partir d'un processus de filtrage dans un filtre (103) et formé à partir d'une suite temporelle de valeurs de sortie du filtre, dans lequel, dans une première étape, des valeurs de mesure brutes (102) ont été obtenues au moyen d'un dispositif (101), et le signal utile (104) a été déterminé au moyen du filtre (103) à partir des valeurs de mesure brutes (102), dans lequel, dans une deuxième étape de procédé, une caractéristique de filtrage du filtre (103) est déterminée au moyen d'une unité d'évaluation (106) à partir d'une suite temporelle de valeurs de sortie, obtenue sous des conditions de mesure stables, et dans une troisième étape de procédé, la caractéristique de filtrage déterminée est inversée, des valeurs de mesure brutes (102) sont reconstituées à partir de l'inverse de la caractéristique de filtrage et du signal utile (104), et à partir des valeurs de mesure brutes (102) reconstituées, les propriétés statistiques de celles-ci sont déterminées, et/ou ces propriétés statistiques sont déterminées directement à partir de l'inverse de la caractéristique de filtrage et du signal utile (104), les propriétés statistiques étant une variance, le procédé comprenant le fait de formuler une affirmation concernant les conditions de mesure au moyen de la variance, uniquement à partir du signal utile, et même sans connaissance précise du filtre, concernant les conditions de mesure, une présence de conditions de mesure stables étant identifiée

(a) à partir d'une évaluation de la suite temporelle des valeurs de sortie, et/ou

(b) à partir d'une évaluation de signaux de capteur d'autres dispositifs de capteur.

2. Procédé selon la revendication 1, **caractérisé en ce qu'**une présence de conditions de mesure stables est identifiée à partir d'une suite temporelle de valeurs de sortie au moins presque homogènes, de préférence au moins presque constantes dans le temps ou variables dans le temps de manière presque uniforme selon un modèle du système à la base du filtre (103).

3. Procédé selon une ou plusieurs des revendications précédentes, **caractérisé en ce que** le processus de filtrage est effectué selon un filtrage passe-bas.

4. Procédé selon une ou plusieurs des revendications 1 à 3, **caractérisé en ce que** le processus de filtrage est effectué selon un filtrage de Kalman.

5. Dispositif (100) permettant d'effectuer un procédé selon une ou plusieurs des revendications précédentes, comprenant un dispositif (101) d'obtention de valeurs de mesure brutes, un filtre (103) pour obtenir un signal utile (104) à partir des valeurs de mesure brutes (102), ainsi qu'une unité de traitement de signal utile (105) présentant une unité d'évaluation (106) pour déterminer une caractéristique de filtrage du filtre (103), reconstituer les valeurs de mesure brutes (102) et déterminer des propriétés statistiques des valeurs de mesure brutes (102).

6. Produit de programme informatique, présentant des parties de programme qui, lors de l'exécution du programme par un ordinateur, ont pour effet que celui exécute l'un des procédés selon au moins l'une des revendications précédentes 1 à 4.

7. Support de données lisible par machine, en particulier lisible par ordinateur, sur lequel est enregistré et/ou stocké au moins un produit de programme informatique selon la revendication 6.

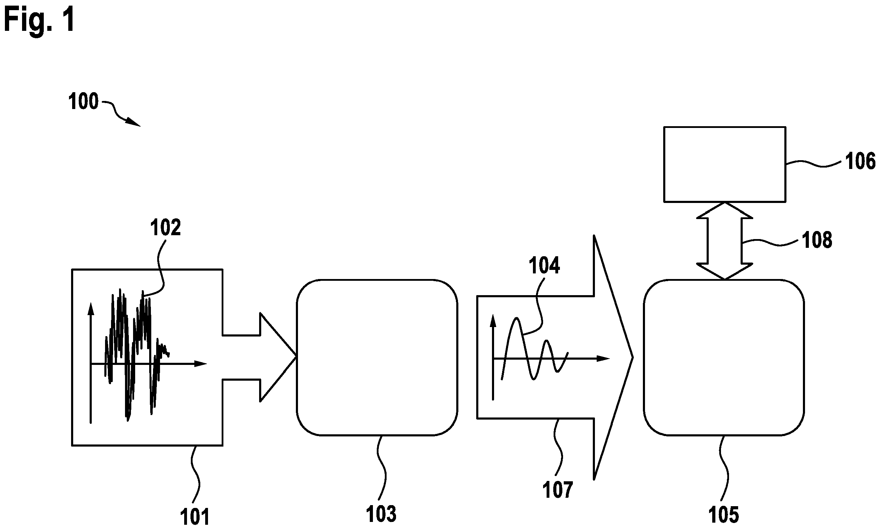

# Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FREDRIK GUSTAFSSON.** Adaptive Filtering and Change Detection. John Wiley & Sons, Ltd, 2000, 312

- **BRAASCH et al.** A SIGNAL MODEL FOR GPS. *NAVIGATION,* 01. Marz 1991, vol. 37 (4), 363-378